# EUROPÄISCHE PATENTSCHRIFT

(11) **EP 3 410 466 B1**
(45) Veröffentlichungstag und Bekanntmachung des Hinweises auf die Patenterteilung: **26.02.2020**
(21) Anmeldenummer: 17173940.2
(22) Anmeldetag: 01.06.2017
(51) Int. Cl.: H01L 21/205

(54) **NEUE CHLORSILYLARYLGERMANE, VERFAHREN ZU DEREN HERSTELLUNG UND DEREN VERWENDUNG**
CHLOROSILYLARYLGERMANE DERIVATIVES, PROCESS FOR THEIR PRODUCTION AND USE THEREOF
DERIVES DE CHLOROSILYLARYLGERMANE, PROCEDE POUR LEUR PRODUCTION ET LEUR UTILISATION

(43) Veröffentlichungstag der Anmeldung: 05.12.2018
(62) Teilanmeldung aus: 17197538.6
(73) Patentinhaber: Evonik Operations GmbH, 45128 Essen (DE)
(72) Erfinder: Teichmann, Julian, 60327 Frankfurt am Main (DE); Wagner, Matthias, 61194 Niddatal (DE); Lerner, Hans-Wolfram, 61440 Oberursel (DE)
(74) Vertreter: Evonik Patent Association

(56) Entgegenhaltungen:
- WO-A2-2004/036631

## Beschreibung

Die vorliegende Erfindung betrifft neue Chlorsilylarylgermane, ein Verfahren zur deren Herstellung sowie deren Verwendung.

Halogensilane, Polyhalogensilane, Halogengermane, Polyhalogengermane, Silan, Polysilane, German, Polygermane sowie entsprechende Mischverbindungen sind lange bekannt, vgl. neben den gängigen Lehrbüchern der anorganischen Chemie auch WO 2004/036631 A2 oder C.J. Ritter et al., J. Am. Chem. Soc., 2005, 127, 9855-9864.

L. Müller et al. beschreiben in J. Organomet. Chem., 1999, 579, 156-163, u.a. die Herstellung von Trichlorsilylmethylgermanen.

Aus der Angew. Chem., 1993, 105, 587-588 (G. Sih et al.) sowie aus Tetrahedron Lett., 1970, 51, 4443-4447 (F. Feher et al.) sind Methylgermylsilane sowie Phenylgermylsilane bekannt.

Ferner sind Phenyl- und Wasserstoff-enthaltende Verbindungen bekannt, in denen Sn-Sisowie Sn-Ge-Bindungen vorliegen (J.B. Tice et al., J. Inorganic Chemistry, 2009, 48(13), 6314-6320). Dabei wird angeregt, diese Verbindungen als IR Halbleiter zu verwenden.

Singh et al. offenbaren in der Patentschrift US 7,540,920 B2 Si-Ge Verbindungen der Formel X₁X₂X₃-Si-Ge- X₄X₅X₆ mit Wasserstoff- oder Halogen-Resten X₁₋₆.

Über Chlorsilylarylgermane ist bis heute praktisch nichts bekannt. So ist man seitens der Grundlagenforschung bestrebt, neue Verbindungen aufzufinden und neue Herstellungswege zu suchen, insbesondere auch mit Hinblick auf mögliche industrielle sowie ggf. verbesserbare Anwendungen.

Der vorliegenden Erfindung lag die Aufgabe zugrunde, neue Silicium-Germanium Verbindungen sowie ein Verfahren zu deren Herstellung bereit zu stellen.

Überraschenderweise wurde als neue Synthesemöglichkeit zur Herstellung von Silicium-Germanium Verbindungen, insbesondere
R₃Ge-SiCl₃, Cl₃Si-GeR₂-GeR₂-SiCl₃, Cl₃Ge-SiCl₃, [Ph₄P][Ge(SiCl₃)₃],
[Ph₄P][Ge(SiCl₃)₃^{∗}GaCl₃], [Ph₄P][Ge(SiCl₃)₃^{∗}BBr₃],
die Umsetzung von chlorierten oder perchlorierten, organischen oder nicht organischen Germaniumverbindungen des Typs RₙGeCl₄₋ₙ (n = 0,2,3) mit Hexachlordisilan unter Zugabe von katalytischen Mengen eines Ammoniumchloridsalzes [R₄N]Cl oder eines Phosphoniumsalzes [R₄P]Cl mit den Resten R = Me, Et, *i*Pr, *n*Bu bzw. unter Zugabe von stöchiometrischen Mengen solcher Salze gefunden. Durch die erfindungsgemäße Umsetzung werden verschiedene Silicium-Germanium Verbindungen erhalten.

Des Weiteren wurde gefunden, dass Edukte des Typs R₃GeCl sich durch die Reaktion mit Si₂Cl₆ in Anwesenheit von Ammoniumchlorid umsetzen, wobei an der Ge-Cl Position eine Ge-Si Bindungsknüpfung stattfindet. Bei der Umsetzung von R₂GeCl₂ mit Si₂Cl₆/Ammoniumchlorid erfolgt die Ge-Si Bindungsbildung nur an einer Ge-Cl Position. Zusätzlich tritt eine Ge-Ge Bindungsknüpfung an der zweiten Ge-Cl Position auf. Die so gefundenen bzw. hergestellten Germanium-Silicium-Verbindungen lassen sich mit LiAlH₄ in Siliciumhydridverbindungen überführen. Solche Verbindungen werden im Rahmen der Erfindung am Beispiel Ph₃Ge-SiCl₃ mit der Synthese von Ph₃Ge-SiH₃ hergestellt. Im Fall der Reaktionen von Verbindungen des Typs RₙGeCl₄₋ₙ (n = 0) finden je nach Stöchiometrie unterschiedliche Reaktionen statt.
Es wurden
[R₄N][GeCl₃]- Salze (GeCl₄:Si₂Cl₆:[R₄N]Cl, 1:1:1),
Cl₃Si-GeCl₃ (GeCl₄:Si₂Cl₆:[R₄N]Cl, 1:1:0.1), oder
[Ph₄P][Ge(SiCl₃)₃] (GeCl₄:Si₂Cl₆:[Ph₄P]Cl, 1:4:1)
erzeugt. [Ph₄P][Ge(SiCl₃)₃] lässt sich mit Lewis-Säuren, abgekürzt "LS", zu den entsprechenden Addukten [Ph₄P][Ge(SiCl₃)₃^{∗}LS] umsetzen.

Im Rahmen der Erfindung wird unter dem Maß "equivalent", kurz "eq.", die Menge des Katalysators in mol bezogen auf die Menge Hexachlordisilan in mol verstanden. Beispielsweise bedeutet 0,1 eq. Katalysator 0,1 mol Katalysator pro mol Hexachlordisilan oder 10 mol-% Katalysator bezogen auf Hexachlordisilan.

Im Rahmen der Erfindung wird "Hexachlordisilan" auch mit "HCDS" abgekürzt.

Gegenstand der vorliegenden Erfindung sind demnach Chlorsilylarylgermane der allgemeinen Formel (I)

XGe(Y₂)-SiCl₃ (I),

wobei X = Y oder X = [-Ge(Y₂)-SiCl₃] ist und die Gruppen Y unabhängig voneinander für Phenyl (Ph) stehen.

Gegenstand ist ebenfalls ein Verfahren zur Herstellung eines erfindungsgemäßen Chlorsilylarylgerman, indem man
(a) ein Arylchlorgerman mit Hexachlordisilan in einem Lösemittel löst und
(b) in Gegenwart eines Katalysator bei einer Temperatur von 5 bis 40 °C umsetzt, wobei die Aryl-Gruppen des Arylchlorgermans unabhängig voneinander für Phenyl
stehen.

Die Erfindung wird im Folgenden näher erläutert.

Die Chlorsilylarylgermane gemäß der Erfindung können ausgewählt sein aus der Reihe Trichlorsilyltriphenylgerman und/oder 1,2-Bis(trichlorsilyl)-1,1,2,2-tertraphenyldigerman.

Im Schritt (b) des erfindungsgemäßen Verfahrens kann es vorteilhaft sein, die Umsetzung bei Raumtemperatur durchzuführen.

Vorzugsweise kann man im Schritt (a) des Verfahrens ein Triarylchlorgerman in einem molaren Verhältnis zu Hexachlordisilan von 1 zu 1 und/oder ein Diaryldichlorgerman in einem molaren Verhältnis zu Hexachlordisilan von 1 zu 2 einsetzen.

Weiterhin kann bevorzugt ein Arylchlorgerman aus der Reihe Triphenylchlorgerman und/oder Diphenyldichlorgerman eingesetzt werden.

Das im Schritt (a) eingesetzte Lösemittel ist vorzugsweise inert gewählt, um unerwünschte Umsetzungen mit HCDS zu vermeiden. Besonders vorteilhaft kann Dichlormethan eingesetzt werden, da dieses in den gewählten Temperaturbereichen nicht mit HCDS reagiert.

Es kann weiterhin vorteilhaft sein, bei der Durchführung des erfindungsgemäßen Verfahrens als Katalysator Phosphoniumchloride [R₄P]Cl oder Ammoniumchloridsalze [R₄N]Cl einzusetzen, wobei die Reste R ausgewählt sind aus Me, Et, *i*Pr, *n*Bu, Ph. Vorzugsweise kann R = *n*Bu gewählt werden.

Es wird beobachtet, dass die Umsetzung umso langsamer abläuft, je weniger Katalysator man einsetzt. Andererseits sind zu große Mengen Katalysator nicht wünschenswert, da dieser am Ende der Umsetzungsreaktion abgetrennt werden muss. Es wurde gefunden, dass das Verfahren wirtschaftlich im Hinblick auf den Abtrennungsaufwand durchgeführt werden kann, wenn man den Katalysator in einer Menge von 0,001 bis 1 mol pro mol Hexachlordisilan einsetzt. Das Verfahren wird besonders günstig durchgeführt, wenn man von 0,01 bis 0,1 mol pro mol Hexachlordisilan einsetzt.

Ein weiterer Aspekt, das erfindungsgemäße Verfahren wirtschaftlich durchzuführen, ist die Auswahl der Menge des Lösemittels. In dem Verfahren wird vorzugsweise mindestens 5 mol Lösemittel pro mol Hexachlordisilan, besonders bevorzugt von 10 mol bis 100 mol Lösemittel pro mol Hexachlordisilan eingesetzt.

In dem erfindungsgemäßen Verfahrens ist es vorteilhaft, die Umsetzung unter Durchmischung, bevorzugt unter Rühren, und über eine Dauer von 1 bis 24 Stunden, vorzugsweise während 12 h, und weiterhin vorzugsweise unter Schutzgas, bevorzugt unter Stickstoff oder Argon durchzuführen, und anschließend das Lösemittel zu entfernen. Dies kann vorzugsweise in Sauerstoff freier trockener Umgebung vorgenommen werden, besonders bevorzugt in einer isolierten Umgebung, beispielsweise in einer Glovebox, und weiterhin bevorzugt unter Normaldruck oder vermindertem Druck, bevorzugt im Bereich von 1 bis 500 hPa, wobei man gebildete Chlorsilylarylgermane als kristallines Produkt gewinnt.

Mit dem erfindungsgemäßen Verfahren kann auch das interessante Molekül Trichlorsilyltrichlorgerman bereitgestellt werden, welches bereits bei Singh et al. (US 7,540,920 B2) ohne eine Methode zur Herstellung offenbart ist. Hierzu wird das Verfahren einer einfachen Modifikation unterzogen, nämlich, indem anstelle des Arylchlorgerman GeCl₄ eingesetzt wird. Die Umsetzungsreaktion wird dann im Weiteren mit Hexachlordisilan in einem Lösemittel und in Anwesenheit eines Katalysators durchgeführt.

Das erfindungsgemässe Verfahren zur Herstellung von Trichlorsilyltrichlorgerman weist die Schritte auf, dass man GeCl₄ mit Hexachlordisilan in einem Lösemittel löst und in Gegenwart eines Katalysators bei einer Temperatur von 5 bis 40 °C umsetzt.

Es kann vorteilhaft sein, den Katalysator in Mengen von 0,001 bis 1 eq., vorzugsweise von 0,01 bis 0,1 eq. einzusetzen. Eine beispielhafte Durchführung dieses Verfahrens schildert **Beispiel 3.**

Wird dieses Verfahren weiterhin dadurch modifiziert, indem man das Ammoniumchloridsalz [R₄N]Cl oder Phosphoniumchloridsalz [R₄P]Cl anstelle in katalytischer in stöchiometrischer Menge einsetzt, vorzugsweise von 0,5 bis 1,5 eq., besonders bevorzugt 1 eq., dann werden überraschend Halogengermanide erhalten, beispielsweise beim Einsatz von [R₄N]Cl oder [R₄P]Cl Trichlorogermanid. Eine bevorzugte Durchführung mit R = Bu schildert **Beispiel 4.**

Die gemäß **Beispiel 4** durchgeführte Synthese stellt eine neue Möglichkeit zur Gewinnung von [R₄N][GeCl₃]-Salzen dar, indem das Kation [R₄N]⁺ variiert und das gewünschte Chloridsalz zur heterolytischen Spaltung des Si₂Cl₆ verwendet wird. Dies ist besonders interessant, da gefunden worden ist, dass das Kation darüber entscheidet, wie gut eine Verbindung kristallisiert.

So kann man erfindungsgemäß eine große Vielzahl an [R₄N][GeCl₃]- und [R₄P][GeCl₂]-Salzen herstellen. Beispielsweise kann in einer bevorzugten Ausführung dieses Verfahrens [Ph₄P]⁺ als Kation eingesetzt werden, um Tris-Trichlorsilylgermanid zu erhalten **(Beispiel 5).** Des Weiteren kann Tris-Trichlorsilylgermanid mit GaCl₃ umgesetzt werden. Dies wird im **Beispiel 6** erläutert.

Anstelle einer Umsetzung mit GaCl₃ kann Tris-Trichlorsilylgermanid mit BBr₃ erfolgen, wie dies beispielhaft im **Beispiel 7** erläutert ist.

Die erfindungsgemäßen oder erfindungsgemäß hergestellten Si-Ge Verbindungen können als Vorstufe für Materialien dienen, die für die gezielte Abscheidung von dünnen Si-Ge Schichten eingesetzt werden.

Gegenstand ist daher auch die Verwendung des erfindungsgemäßen Chlorsilylarylgermans oder erfindungsgemäß hergestellten Chlorsilylarylgermans für die Erzeugung von Si-Ge Schichten.

Das erfindungsgemäß hergestellte Trichlorsilyltrichlorgerman ist für die Erzeugung von Si-Ge Schichten verwendbar.

Weiterhin können das erfindungsgemäße Chlorsilylarylgerman, das erfindungsgemäß hergestellte Chlorsilylarylgerman bzw. das erfindungsgemäß hergestellte Trichlorsilyltrichlorgerman vorzugsweise unter Umwandlung in die chlorierte Form, in die hydrierte Form, und/oder unter deren thermischer Zersetzung verwendet werden.

Die nachfolgenden Beispiele erläutern die vorliegende Erfindung zusätzlich, ohne den Gegenstand zu beschränken. Der Begriff "Raumtemperatur" wird in den Beispielen mit "RT" abgekürzt.

### Analytische Methoden der Kristallstrukturbestimmung

Die Daten für alle Strukturen wurden bei 173 K mit einem STOE IPDS II Zweikreisdiffraktometer mit einer Genix Mikrofokusröhre mit Spiegeloptik unter Verwendung von Mo*K*_{α} Strahlung (*λ* = 0,71073 Å) gesammelt und mit dem frame scaling procedure des Programms *X-AREA* (Stoe & Cie, 2002) skaliert. Die Strukturen wurden mit direkten Methoden mit Hilfe des Programms *SHELXS* (Sheldrick, 2008) gelöst und gegen *F²* mit der full-matrix least-squares Technik verfeinert. Zellparameter wurden durch Verfeinerung gegen θ Werte der Reflexe mit *I*>6σ(*I*) bestimmt.

### Einsatzstoffe:

Hexachlordisilan, kurz "HCDS", GeCl₄ von Evonik Industries AG, Triphenylchlorgerman, Diphenyldichlorgerman.

### Beispiel 1: Herstellung von Trichlorsilyl-triphenylgerman (1).

Die Synthese erfolgte gemäß **Gleichung 1** aus Ph₃GeCl und Si₂Cl₆ unter Zugabe einer katalytischen Menge von 0,1 eq [*n*Bu₄N]Cl.

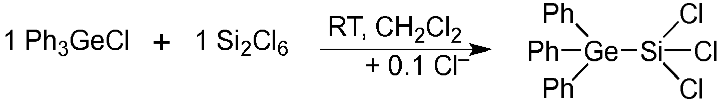

**Gleichung 1:** Umsetzung von Ph₃GeCl und Si₂Cl₆ unter Zugabe der katalytischen Menge von 0,1 eq [*n*Bu₄N]Cl.

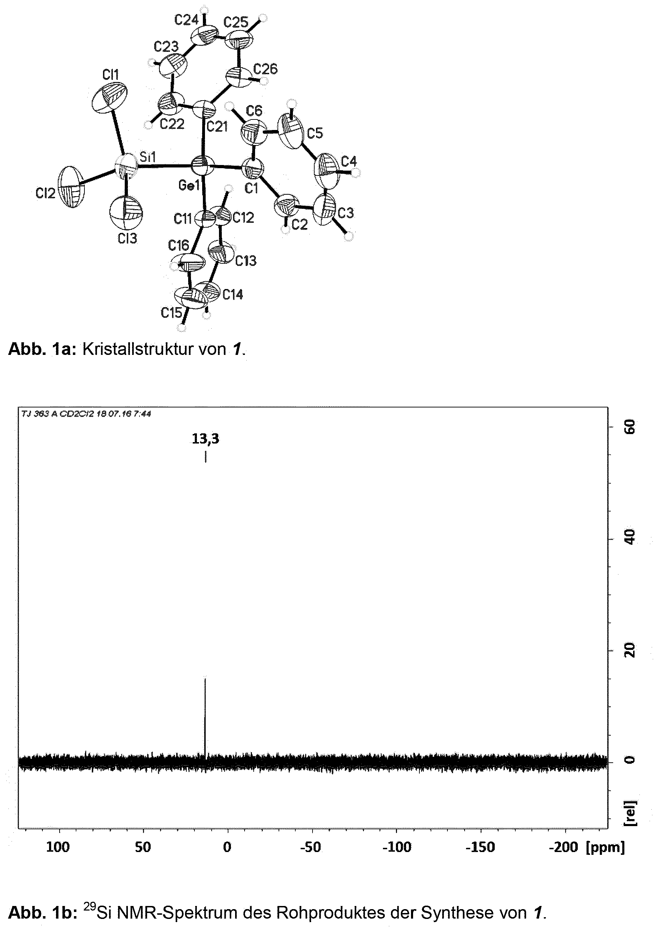

Zu einer klaren, farblosen Lösung aus 500 mg entsprechend 1,47 mmol Ph₃GeCl und 40 mg oder 0,14 mmol [*n*Bu₄N]Cl in 5 ml oder 78,3 mmol CH₂Cl₂ wurden unter Rühren bei Raumtemperatur 400 mg entsprechend 1,49 mmol Si₂Cl₆ gegeben. Es wurde eine klare, farblose Reaktionslösung erhalten, die während 12 h gerührt wurde. Aus der Reaktionslösung ließ sich nach langsamem Entfernen des Lösemittels ein Rohprodukt in Form eines farblosen, kristallinen Feststoffes ***1*** isolieren. Die Ausbeute betrug 59 %. Das Rohprodukt enthielt noch zu etwa 30 % das Edukt Ph₃GeCl. Durch eine röntgendiffraktometrische Untersuchung konnte die Kristallstruktur von ***1*** ermittelt werden (Abb. 1a). Nicht gekennzeichnete Atome stehen in der Abbildung für Wasserstoff.

Das ²⁹Si NMR Spektrum von ***1*** ist in Abb. 1b dargestellt.
Alle Ergebnisse einer ¹H, ¹³C und ²⁹Si NMR-spektroskopischen Untersuchung:
**²⁹Si NMR (99,4 MHz, CD₂Cl₂, 298 K):**
   δ = 13,3.
**¹H NMR (500,2 MHz, CD₂Cl₂, 298 K):**
   δ = 7,58 (m); 7,75 (dd ³J(H,H) = 8,0 Hz, ²J(H,H) = 1,4 Hz).
**¹³C NMR (125,0 MHz, CD₂Cl₂, 298 K):**
   δ = 128,9; 130,1; 132,2; 135,3.

### Beispiel 2:

### Herstellung von 1,2-Bis(trichlorsilyl)-1,1,2,2-tetraphenyldigerman (2).

Die Synthese erfolgte gemäß **Gleichung 2** aus Ph₂GeCl₂ und Si₂Cl₆ unter Zugabe von katalytischen Mengen (0.1 eq) [*n*Bu₄N]Cl.

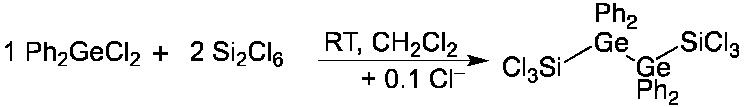

**Gleichung 2:** Umsetzung von Ph₂GeCl₂ und Si₂Cl₆ unter Zugabe von katalytischen Mengen (0.1 eq) [*n*Bu₄N]Cl.

Zu einer klaren, farblosen Lösung, enthaltend 500 mg oder 1,68 mmol Ph₂GeCl₂ und 90 mg oder 0,17 mmol [*n*Bu₄N]Cl in 5 ml oder 78,3 mmol CH₂Cl₂, wurde bei Raumtemperatur 903 mg oder 3,36 mmol Si₂Cl₆ gegeben. Die erhaltene Reaktionslösung wurde anschließend während 12 h bei Raumtemperatrur gerührt.

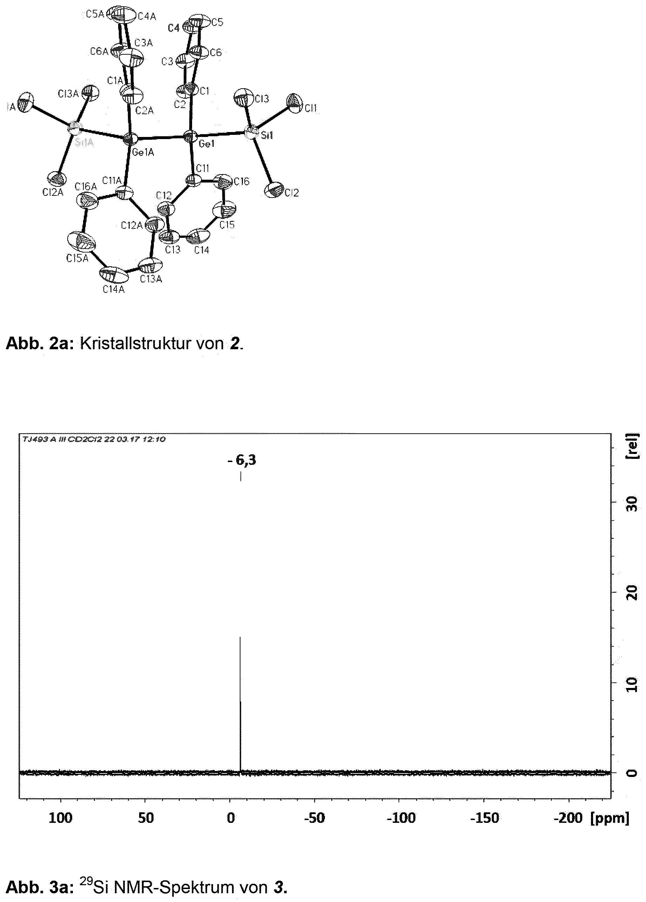

Aus der Reaktionslösung ließ sich nach langsamem Entfernen des Lösemittels ein Rohprodukt in einer Ausbeute von 77 % erhalten, aus dem sich durch Extrahieren mit Et₂O und nachfolgender Auskristallisation als farbloser, kristalliner Feststoff ***2*** isolieren ließ. Die Ausbeute hierfür betrug 57 %. Mittels Röntgendiffraktometrie konnte die Kristallstruktur von ***2*** ermittelt werden, dargestellt in **Abb. 2a****.**

Alle Ergebnisse einer ¹H, ¹³C und ²⁹Si NMR-spektroskopischen Untersuchung:
**²⁹Si NMR (99,4 MHz, CH₂Cl₂, 298 K):**
   δ = 12,3
**¹H NMR (500,2 MHz, CH₂Cl₂, 298 K):**
   δ = 7,41 (t ³J(H,H) = 7,2 Hz (2H)), 7,47 (d ³J(H,H) = 7,2 Hz (1H)), 7,56 (d ³J(H,H) = 7,2 Hz (2H)).
**¹³C NMR (125,0 MHz, CH₂Cl₂, 298 K):**
   δ = 129,0; 130,1; 131,8; 136,0.

### Beispiel 3: Herstellung von Trichlorsilyltrichlorgerman (3).

Die Synthese erfolgte gemäß **Gleichung 3** aus GeCl₄ und Si₂Cl₆ (1:1) unter Zugabe von 0,1 eq. [*n*Bu₄N]Cl als katalytische Menge.

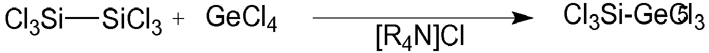

**Gleichung 3:** Umsetzung von GeCl₄ und Si₂Cl₆ (1:1) unter Zugabe von katalytischer Menge (0,1eq.) des Katalysators mit R = Bu: [*n*Bu₄N]Cl.

Zu einer klaren, farblosen Lösung, enthaltend 100 mg oder 0,4 mmol [*n*Bu₄N]Cl in einem 30:70 Gemisch aus GeCl₄ und CH₂Cl₂, wurde bei Raumtemperatur 1 g oder 3,7 mmol Si₂Cl₆ gegeben und das so erhaltene Reaktionsgemisch während 12 h bei Raumtemperatur gerührt. Aus der Reaktionslösung wurde das Produkt ***3*** mit anderen flüchtigen Bestandteilen in eine stickstoffgekühlte Vorlage kondensiert. Eine anschließende Destillation bei 1013 hPa ergab die Isolation von reinem ***3*** in einer Ausbeute von 22% als klare farblose Flüssigkeit.

Das ²⁹Si NMR Spektrum von ***3*** ist in **Abb. 3a** dargestellt.

Alle Ergebnisse einer ²⁹Si NMR-spektroskopischen Untersuchung:
**²⁹Si NMR (99,4 MHz; CH₂Cl₂; 298 K):**
δ = -6,3.

### Beispiel 4: Herstellung von Trichlorogermanid (4).

Es wurde wie im Beispiel 3 vorgegangen, jedoch mit dem Unterschied, dass [*n*Bu₄N]Cl in stöchiometrischer Menge gleichbedeutend 1 eq. eingesetzt wurde. Die Umsetzungsreaktion erfolgte in einer Redox-Reaktion gemäß **Gleichung 4.** 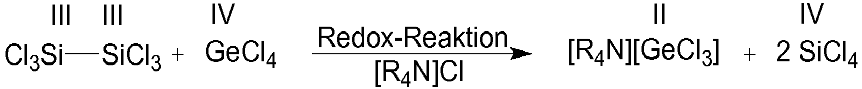 **Gleichung 4:** Umsetzung von GeCl₄ und Si₂Cl₆ (1:1) unter Zugabe von stöchiometrischer Menge, nämlich 1 eq., an [*n*R₄N]Cl mit R = Bu.

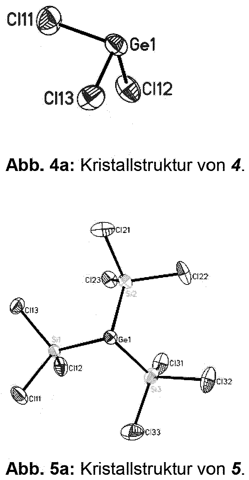

Zu einer klaren farblosen Lösung aus 300 mg oder 1,4 mmol GeCl₄ und 390 mg oder 1,4 mmol [*n*Bu₄N]Cl in CH₂Cl₂ wurden bei Raumtemperatur 375 mg oder 1,4 mmol Si₂Cl₆ gegeben und das so erhaltene Reaktionsgemisch während 12 h bei Raumtemperatur gerührt. Aus der Reaktionslösung ließ sich nach langsamem Entfernen des Lösemittels Trichlorogermanid ***4*** als gelblicher, kristalliner Feststoff isolieren. Durch Röntgendiffraktometrie konnte die Struktur von ***4*** ermittelt werden, gezeigt in **Abb. 4a****.** Das Kation [*n*Bu₄N]⁺ ist hier aus Gründen der Übersichtlichkeit nicht abgebildet.

### Beispiel 5: Herstellung von Tris-Trichlorsilylgermanid (5).

Die Synthese erfolgte gemäß **Gleichung 5** aus GeCl₄ und Si₂Cl₆ in einem molaren Verhältnis von 1:4 unter Zugabe einer stöchiometrischen Menge, in diesem Fall 1 eq., von [Ph₄P]Cl.

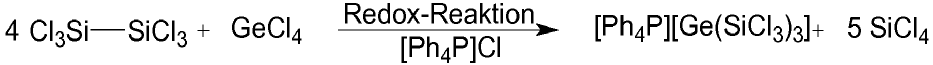

**Gleichung 5:** Umsetzung von GeCl₄ und Si₂Cl₆ (1:4) unter Zugabe von stöchiometrischer Menge (1 eq.) an [Ph₄P]Cl.

Zu einer klaren, farblosen Lösung enthaltend 93 mg oder 0,4 mmol GeCl₄ und 163 mg oder 0,4 mmol [Ph₄P]Cl in CH₂Cl₂ als Lösemittel wurden bei Raumtemperatur 478 mg oder 1,7 mmol Si₂Cl₆ gegeben und das so erhaltene Reaktionsgemisch während 12 h bei Raumemperatur gerührt. Aus diesem Gemisch ließ sich nach langsamem Entfernen des Lösemittels ***5*** als gelblicher, kristalliner Feststoff in 99 % Ausbeute isolieren. Durch Röntgendiffraktometrie konnte die Kristallstruktur von ***5*** ermittelt werden, gezeigt in **Abb. 5a****.** Das Kation [Ph₄P]⁺ ist hier aus Gründen der Übersichtlichkeit nicht abgebildet.

Bei dieser Reaktion kommt es zu einer Reduktion des GeCl₄, zudem erfolgt eine dreifache Silylierung des Germaniumatoms.

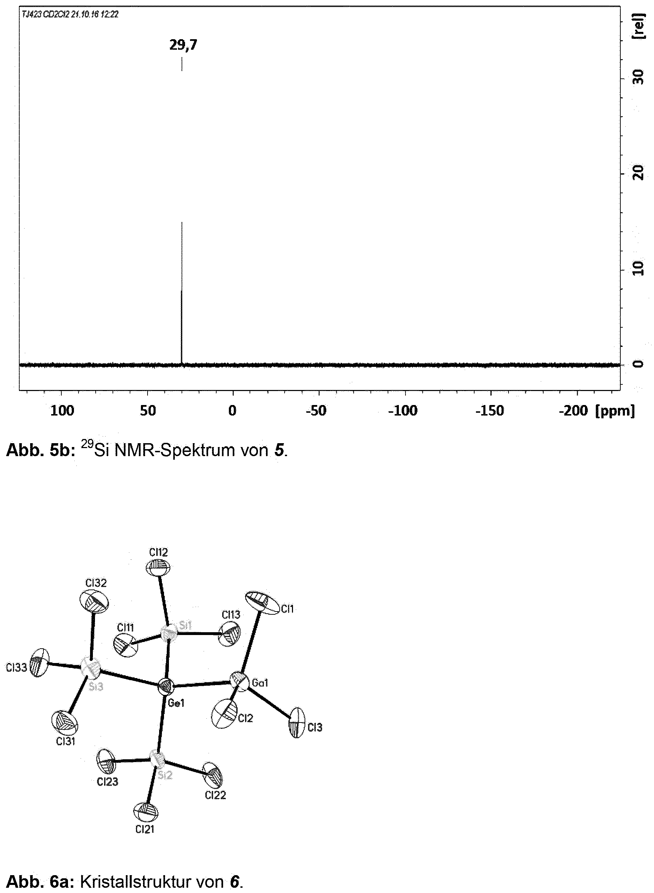

Das ²⁹Si NMR Spektrum von ***5*** ist in **Abb. 5b** dargestellt.

Alle Ergebnisse einer ¹H und ²⁹Si NMR-spektroskopischen Untersuchung:
**²⁹Si NMR (99,4 MHz; CD₂Cl₂; 298 K):**
   δ = 29,7.
**¹H NMR (500,2 MHz; CD₂Cl₂; 298 K):**
   δ = 7,54 (qd ³J(H,H) = 4,5 Hz; ²J(H,H) = 1,3 Hz; (2H)); 7,68 (td ³J(H,H) =7,4 Hz; ³J(H,H) = 3,4 Hz (2H)); 7,84 (tt ³J(H,H) = 7Hz; ²J(H,H) = 1,0 Hz (1H)).

### Beispiel 6: Herstellung von Tris(trichlorsilyl)germanid an GaCl₃ (6) Addukt.

Die Synthese von ***6*** erfolgte gemäß **Gleichung 6** aus Tris-Trichlorsilylgermanid **(5)** und GaCl₃.

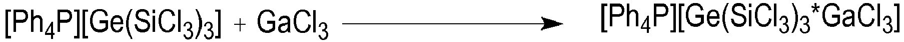

**Gleichung 6:** Umsetzung von ***5*** mit GaCl₃.

50 mg oder 0,1 mmol ***5*** und 10 mg oder 0,1 mmol GaCl₃ wurden als Feststoffe bei Raumtemperatur vermischt und anschließend vollständig in CH₂Cl₂ gelöst. Das klare, gelbe Reaktionsgemisch wurde während 12 h bei Raumtemperatur gerührt. Aus der klaren, gelben Reaktionslösung ließ sich nach langsamem Entfernen des Lösemittels ***6*** als gelber kristalliner Feststoff in einer Ausbeute von 82 % erhalten.

Durch Röntgendiffraktometrie konnte die Kristallstruktur von ***6*** ermittelt werden, gezeigt in **Abb. 6a****.** Das Kation [Ph₄P]⁺ ist hier aus Gründen der Übersichtlichkeit nicht abgebildet.

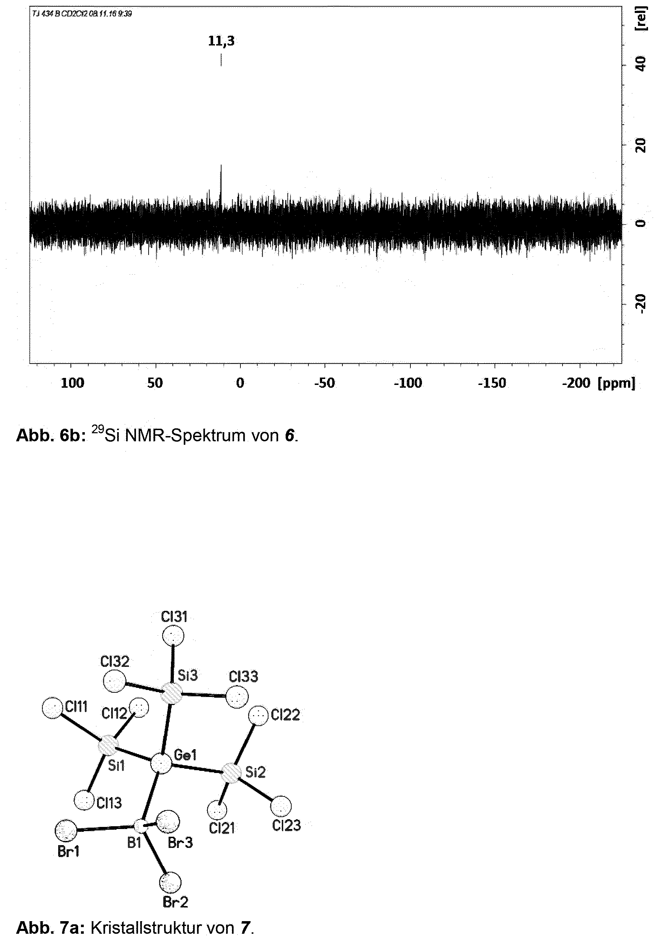

Das ²⁹Si NMR Spektrum von ***6*** ist in **Abb. 6b** dargestellt.

Alle Ergebnisse einer ¹H und ²⁹Si NMR-spektroskopischen Untersuchung:
**²⁹Si NMR (99,4 MHz; CD₂Cl₂; 298 K):**
   δ = 11,3.
**¹H NMR (500,2 MHz; CD₂Cl₂; 298 K):**
   δ = 7,54 (qd ³J(H,H) = 4,5 Hz; ²J(H,H) = 1,3 Hz; (2H)); 7,68 (td ³J(H,H) =7,4 Hz; ³J(H,H) = 3,4 Hz (2H)); 7,84 (tt ³J(H,H) = 7Hz; ²J(H,H) = 1,0 Hz (1H)).

### Beispiel 7: Herstellung von Tris(trichlorsilyl)germanid an BBr₃ (7) Addukt.

Die Synthese von ***7*** erfolgte gemäß **Gleichung 7** aus Tris-Trichlorsilylgermanid **(*5*)** und BBr₃. 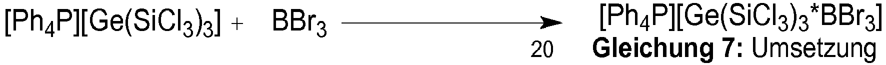 von 5 mit BBr₃.

Zu einer klaren gelben Lösung von ***5*** in CH₂Cl₂ wurde bei Raumtemperatur BBr₃ gegeben. Nach 4 Tagen waren farblose Kristalle aus der so erhaltenen gelben Reaktionslösung ausgefallen. Durch Röntgendiffraktometrie konnte die Kristallstruktur von ***7*** ermittelt werden, gezeigt in **Abb. 7a****.** Das Kation [Ph₄P]⁺ ist hier aus Gründen der Übersichtlichkeit nicht abgebildet.

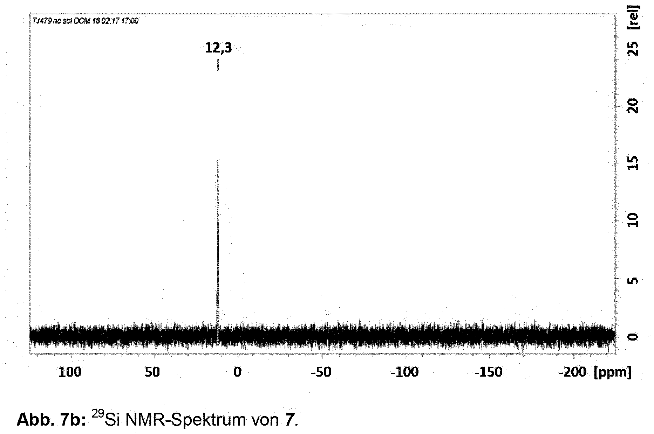

Das ²⁹Si NMR Spektrum von ***7*** ist in **Abb. 7b** dargestellt.

Alle Ergebnisse einer ¹¹B und ²⁹Si NMR-spektroskopischen Untersuchung
**²⁹Si NMR (99,4 MHz; CD₂Cl₂; 298 K):**
δ = 12,3.
**¹¹B NMR (160,5 MHz; CD₂Cl₂; 298 K):**
δ = -17,5.

## Patentansprüche

1. Chlorsilylarylgermane der allgemeinen Formel (I)
XGe(Y₂)-SiCl₃ (I)
wobei X = Y oder X = [-Ge(Y₂)-SiCl₃] ist und
die Gruppen Y unabhängig voneinander für Phenyl (Ph) stehen.

2. Chlorsilylarylgermane nach Anspruch 1 ausgewählt aus der Reihe Trichlorsilyltriphenylgerman und/oder 1,2-Bis(trichlorsilyl)-1,1,2,2-tetraphenyldigerman.

3. Verfahren zur Herstellung eines Chlorsilylarylgerman nach Anspruch 1 oder 2 indem man
(a) ein Arylchlorgerman mit Hexachlordisilan in einem Lösemittel löst und
(b) in Gegenwart eines Katalysators bei einer Temperatur von 5 bis 40 °C umsetzt, wobei die Aryl-Gruppen des Arylchlorgermans unabhängig voneinander für Phenyl stehen.

4. Verfahren nach Anspruch 3, wobei die Umsetzung bei Raumtemperatur durchgeführt wird.

5. Verfahren nach Anspruch 3, **dadurch gekennzeichnet, dass** man ein Triarylchlorgerman in einem molaren Verhältnis zu Hexachlordisilan, kurz HCDS, von 1 zu 1 und/oder ein Diaryldichlorgerman in einem molaren Verhältnis zu Hexachlordisilan von 1 zu 2 einsetzt.

6. Verfahren nach einem der Ansprüche 3 bis 5, **dadurch gekennzeichnet, dass** man ein Arylchlorgerman aus der Reihe Triphenylchlorgerman und/oder Diphenyldichlorgerman einsetzt.

7. Verfahren nach einem der Ansprüche 3 bis 6, **dadurch gekennzeichnet, dass** man als Lösemittel Dichlormethan einsetzt.

8. Verfahren nach einem der Ansprüche 3 bis 7, **dadurch gekennzeichnet, dass** man als Katalysator Phosphoniumchloride [R₄P]Cl oder Ammoniumchloridsalz [R₄N]Cl, die Reste R ausgewählt aus Me, Et, *i*Pr, *n*Bu, Ph, vorzugsweise R = *n*Bu, einsetzt.

9. Verfahren nach einem der Ansprüche 3 bis 8, **dadurch gekennzeichnet, dass** man den Katalysator in einer Menge von 0,001 bis 1 mol pro mol Hexachlordisilan, vorzugsweise von 0,01 bis 0,1 mol pro mol Hexachlordisilan einsetzt.

10. Verfahren nach einem der Ansprüche 3 bis 9, **dadurch gekennzeichnet, dass** man mindestens 5 mol Lösemittel pro mol Hexachlordisilan, bevorzugt von 10 mol bis 100 mol Lösemittel pro mol Hexachlordisilan einsetzt.

11. Verfahren nach einem der Ansprüche 3 bis 10, **dadurch gekennzeichnet, dass** man die Umsetzung
unter Durchmischung, bevorzugt unter Rühren, und
über eine Dauer von 1 bis 24 Stunden, vorzugsweise während 12 h, und
vorzugsweise unter Schutzgas, bevorzugt unter Stickstoff oder Argon, durchführt, und anschließend
das Lösemittel entfernt, vorzugsweise in Sauerstoff freier trockener Umgebung, besonders bevorzugt in einer isolierten Umgebung,
weiterhin bevorzugt unter Normaldruck oder vermindertem Druck, bevorzugt im Bereich von 1 bis 500 hPa,
und gebildete Chlorsilylarylgermane als kristallines Produkt gewinnt.

12. Verwendung eines Chlorsilylarylgermans nach Anspruch 1 oder 2 oder hergestellt nach Anspruch 3 bis 11 für die Erzeugung von GeSi-Schichten.

## Claims

1. Chlorosilylarylgermanes of the general formula (I)
XGe(Y₂)-SiCl₃ (I)
where X = Y or X = [-Ge(Y₂)-SiCl₃] and
the Y groups are each independently phenyl (Ph).

2. Chlorosilylarylgermanes according to Claim 1 selected from the series comprising trichlorosilyltriphenylgermane and/or 1,2-bis(trichlorosilyl)-1,1,2,2-tetraphenyldigermane.

3. Method for preparing a chlorosilylarylgermane according to Claim 1 or 2,
by
(a) dissolving an arylchlorogermane with hexachlorodisilane in a solvent and
(b) reacting in the presence of a catalyst at a temperature of 5 to 40°C, wherein the aryl groups of the arylchlorogermane are each independently phenyl.

4. Method according to Claim 3, wherein the reaction is carried out at room temperature.

5. Method according to Claim 3, **characterized in that** a triarylchlorogermane is used in a molar ratio to hexachlorodisilane, HCDS for short, of 1:1 and/or a diaryldichlorogermane is used in a molar ratio to hexachlorodisilane of 1:2.

6. Method according to any of Claims 3 to 5, **characterized in that** an arylchlorogermane is used from the series comprising triphenylchlorogermane and/or diphenyldichlorogermane.

7. Method according to any of Claims 3 to 6, **characterized in that** dichloromethane is used as solvent.

8. Method according to any of Claims 3 to 7, **characterized in that** phosphonium chlorides [R₄P]Cl or ammonium chloride salt [R₄N]Cl, the radicals R selected from Me, Et, *i*Pr, *n*Bu, Ph, preferably R = nBu, are used as catalyst.

9. Method according to any of Claims 3 to 8, **characterized in that** the catalyst is used in an amount of 0.001 to 1 mol per mole of hexachlorodisilane, preferably 0.01 to 0.1 mol per mole of hexachlorodisilane.

10. Method according to any of Claims 3 to 9, **characterized in that** at least 5 mol of solvent is used per mole of hexachlorodisilane, preferably 10 mol to 100 mol of solvent per mole of hexachlorodisilane.

11. Method according to any of Claims 3 to 10, **characterized in that** the reaction is carried out
with thorough mixing, preferably with stirring, and
over a period of 1 to 24 hours, preferably over the course of 12 h, and
preferably under protective gas, preferably under nitrogen or argon,
and the solvent is subsequently
removed, preferably in a dry oxygen-free environment, particularly preferably in an isolated environment,
further preferably at standard pressure or under reduced pressure, preferably in the range of 1 to 500 hPa,
and chlorosilylarylgermanes formed are obtained as crystalline product.

12. Use of a chlorosilylarylgermane according to Claim 1 or 2 or prepared according to Claims 3 to 11 for generating GeSi layers.

## Revendications

1. Chlorosilylarylgermanes de formule générale (I)
XGe(Y₂)-SiCl₃ (I)
X = Y ou X = [-Ge(Y₂)-SiCl₃] et
les groupes Y représentant indépendamment l'un de l'autre phényle (Ph).

2. Chlorosilylarylgermanes selon la revendication 1, choisis dans la série trichlorosilyltriphénylgermane et/ou 1,2-bis(trichlorosilyl)-1,1,2,2-tétraphényldigermane.

3. Procédé pour la préparation d'un chlorosilylarylgermane selon la revendication 1 ou 2, dans lequel
(a) on dissout un arylchlorogermane avec de l'hexachlorodisilane dans un solvant et
(b) on réalise la transformation en présence d'un catalyseur à une température de 5 à 40 °C, les groupes aryle de l'arylchlorogermane représentant indépendamment l'un de l'autre phényle.

4. Procédé selon la revendication 3, la transformation étant mise en œuvre à température ambiante.

5. Procédé selon la revendication 3, **caractérisé en ce qu'**on utilise un triarylchlorogermane en un rapport molaire à l'hexachlorodisilane, abrégé HCDS, de 1 à 1 et/ou un diaryldichlorogermane en un rapport molaire à l'hexachlorodisilane de 1 à 2.

6. Procédé selon l'une quelconque des revendications 3 à 5, **caractérisé en ce qu'**on utilise un arylchlorogermane de la série triphénylchlorogermane et/ou diphényldichlorogermane.

7. Procédé selon l'une quelconque des revendications 3 à 6, **caractérisé en ce qu'**on utilise du dichlorométhane en tant que solvant.

8. Procédé selon l'une quelconque des revendications 3 à 7, **caractérisé en ce qu'**on utilise des chlorures de phosphonium [R₄P]Cl ou un sel de chlorure d'ammonium [R₄N]Cl en tant que catalyseur, les radicaux R étant choisis parmi Me, Et, *i*Pr, *n*Bu, Ph, de préférence R = *n*Bu.

9. Procédé selon l'une quelconque des revendications 3 à 8, **caractérisé en ce qu'**on utilise le catalyseur en une quantité de 0,001 à 1 mole par mole d'hexachlorodisilane, de préférence de 0,01 à 0,1 mole par mole d'hexachlorodisilane.

10. Procédé selon l'une quelconque des revendications 3 à 9, **caractérisé en ce qu'**on utilise au moins 5 moles de solvant par mole d'hexachlorodisilane, préférablement 10 moles à 100 moles de solvant par mole d'hexachlorodisilane.

11. Procédé selon l'une quelconque des revendications 3 à 10, **caractérisé en ce qu'**on met en œuvre la transformation
Par brassage, de préférence par agitation, et pendant une durée de 1 à 24 heures, de préférence pendant 12 h, et
de préférence sous gaz protecteur, préférablement sous azote ou sous argon, et ensuite
on élimine le solvant, de préférence dans un environnement sec, exempt d'oxygène, particulièrement préférablement dans un environnement isolé, encore préférablement sous pression normale ou sous pression réduite, préférablement dans la plage de 1 à 500 hPa,
et on obtient des chlorosilylarylgermanes formés en tant que produit cristallin.

12. Utilisation d'un chlorosilylarylgermane selon la revendication 1 ou 2 ou préparé selon la revendication 3 à 11 pour la production de couches de GeSi.
